# EUROPÄISCHE PATENTSCHRIFT

(11) **EP 2 091 080 B1**
(45) Veröffentlichungstag und Bekanntmachung des Hinweises auf die Patenterteilung: **05.08.2015**
(21) Anmeldenummer: 08018434.4
(22) Anmeldetag: 22.10.2008
(51) Int. Cl.: H01L 23/04, H01L 23/48, H01L 23/498, H01L 25/07, H05K 1/02

(54) **Leistungshalbleitermodul mit einem Substrat und einer Druckeinrichtung**
Power semiconductor module with a substrate and a pressure device
Module semi-conducteur de puissance doté d'un substrat et d'un dispositif de mise sous pression

(30) Priorität: 16.11.2007 DE 102007054709
(43) Veröffentlichungstag der Anmeldung: 19.08.2009
(73) Patentinhaber: SEMIKRON Elektronik GmbH & Co. KG, 90431 Nürnberg (DE)
(72) Erfinder: Popp, Rainer, 91580 Petersaurach (DE); Gruber, Markus, 90518 Altdorf (DE)

(56) Entgegenhaltungen:
- EP-A- 1 592 063
- DE-A1- 19 719 703
- DE-A1- 19 903 875
- DE-C1- 10 127 947
- US-A- 4 772 210
- US-A- 6 059 615

## Beschreibung

Die Erfindung beschreibt ein kompaktes druckkontaktiertes grundplattenloses Leistungshalbleitermodul wie im Anspruch 1 beschrieben, mit einem rahmenartigen isolierenden Gehäuse, mit mindestens einem Substrat und mit einer Druckeinrichtung.

Einen Ausgangspunkt der Erfindung bilden Leistungshalbleitermodule, wie sie beispielhaft aus der DE 197 19 703 A1 bekannt sind. Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter strukturierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf.

Ebenfalls bekannt sind druckkontaktierte Leistungshalbleitermodule, wie sie in der DE 199 03 875 A1 oder der DE 101 27 947 C1 offenbart sind.

Bei erstgenannter Druckschrift weist das Leistungshalbleitermodul eine Druckeinrichtung auf, welche aus einem stabilen Druckelement zur Druckeinleitung besteht, wobei dieses ein vorteilhaftes Verhältnis aus Gewicht und Stabilität aufweist und hierzu als ein Kunststoffformkörper mit innen liegender Metallseele ausgebildet ist und weiterhin elektrisch isolierende Durchführungen aufweist.
Weiterhin weist die Druckeinrichtung ein elastisches Kissenelement zur Druckspeicherung und ein Brückenelement zur Druckeinleitung auf gesonderte Bereiche der Substratoberfläche auf. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgeht. Mittels einer derartigen Druckeinrichtung wird das Substrat vorzugsweise auf ein Kühlbauteil gedrückt und somit der Wärmeübergang zwischen dem Substrat und dem Kühlbauteil dauerhaft sicher hergestellt.

Aus der DE 101 27 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende innere Kontakteinrichtungen aufweisen, die den elektrischen Kontakt zu den Leiterbahnen herstellen und gleichzeitig Druck auf das Substrat ausüben und somit vorzugsweise dessen thermischen Kontakt zu einem Kühlbauteil herstellen. Der Druck wird hierbei beispielhaft mit oben genannten Mitteln nach dem Stand der Technik eingeleitet.

Die US-Anmeldung US 6059615 weist eine elektrische Verbindungseinrichtung für eine Vielzahl von in Reihe geschalteten Segmenten. beispielhaft Leistungsmodule oder Signalmodule, auf. Dabei weisen die Segmente Durchgänge und eine Führung für einen Befestigungsstift auf, der die beiden Segmente miteinander verbindet.

Die US - Anmeldung US 4772210 weist eine Leiterplatte für eine Vielzahl von elektronischen Bauteilen auf. Die Kontaktelemente der elektronischen Bauteile sind teilweise in Durchführungen der Leiterplatte angeordnet und werden beispielhaft durch Löten mit der Kontaktstelle der Leiterplatte verbunden. Dadurch werden die Bauteile auf der Leiterplatte fixiert und elektronisch mit Leiterbahnen verbunden.

Die EP 1592063 A2 weist eine Anordnung in Druckkontaktierung für kompakte Leistungsmodule auf, die Fortsätze der Kühleinrichtung aufweist, welche durch die Leiterplatte hindurchragen und durch eine Rastnase reversibel oder unreversibel angeordnet ist. Durch diese Anordnung wird der benötigte Druck auf die Kontaktfeder aufgebracht und somit der elektrische Kontakt zwischen Substrat, auf dem die Leistungshalbleiterbauelemente angeordnet, und der Leiterplatte für externe Anschlüsse hergestellt wird.

Nachteilig ist hierbei, dass bei derartig ausgeformten grundplattenlosen Leistungshalbleitermodulen bei der Druck einleitenden Kontaktierung der inneren Kontakteinrichtungen mit den Leiterbahnen des Substrats durch das Fehlen einer Grundplatte das elektrisch isolierende Substrat im Montageprozess nicht gegen ein Verdrehen gegen das rahmenartige Gehäuse geschützt ist. Die Krafteinwirkung des Verdrehprozesses des Substrates gegen das Gehäuse führt während der Montage möglicherweise zu einer Beschädigung des Substrates und damit zu einer Leistungseinbuße bis hin zur Zerstörung des Leistungshalbleitermoduls.

Als nachteilig erweist sich weiterhin, dass bei derartigen Leistungshalbleitermodulen, welche als Last- und Hilfsanschlusselemente Federkontaktelemente aufweisen, diese Federkontaktelemente durch die Druckeinleitung mit ihrer inneren Kontakteinrichtung seitlich von der strukturierten Leiterbahn abrutschen und einen Kontaktverlust verursachen, welcher zu einer verminderten Leistung des Leistungshalbleitermoduls, im Extremfall zu dessen Totalausfall führen kann.

Der Erfindung liegt die Aufgabe zugrunde, ein Leistungshalbleitermodul mit einer Druckeinrichtung und einem Substrat vorzustellen, wobei das Substrat gegen Verdrehen im Montageprozess gesichert ist und das Leistungshalbleitermodul einer einfachen und kostengünstigen Herstellung zugänglich ist.

Die Aufgabe wird erfindungsgemäß gelöst durch die Maßnahmen der Merkmale des Anspruchs 1. Bevorzugte Ausführungsformen sind in den Unteransprüchen beschrieben.

Der erfinderische Gedanke geht aus von den Anforderungen eines Leistungshalbleitermoduls mit einem Substrat, mit mindestens einem anzuordnenden und schaltungsgerecht zu verbindenden Leistungshalbleiterbauelement und mit einem Gehäuse mit einer Druckeinrichtung und mit nach außen führenden Last- und Hilfsanschlusselementen. Das Substrat weist einen Isolierstoffkörper auf, wobei auf dessen einer, dem Inneren des Leistungshalbleitermoduls zugewandten Hauptfläche strukturierte Leiterbahnen mit Lastpotential angeordnet sind. Weiterhin weist das Substrat strukturierte Leiterbahnen mit Hilfspotential zur Ansteuerung der Leistungshalbleiterbauelemente auf.

Die Druckeinrichtung besteht aus einem Druck einleitenden Druckelement, welches vorzugsweise gleichzeitig den Deckel des Gehäuses bildet, und vorzugsweise Weiterhin aus einem Brückenelement zur Druckeinleitung auf die auf dem Substrat angeordneten Leiterbahnen, welches kanalartige Ausnehmungen zur Durchführung von Lastanschlusselementen und weiterhin bevorzugt eine Mehrzahl von Druckfingern in Richtung der Substratoberfläche aufweist. Vorzugsweise weist die Druckeinrichtung des Weiteren ein elastisches Kissenelement zur Druckspeicherung und der Aufrechterhaltung konstanter Druckverhältnisse auf. Beispielhaft können das Druck einleitende Element und das Brückenelement auch einstückig ohne Kissenelement ausgestaltet sein. Ebenso kann beispielhaft das Brückenelement einstückig mit dem rahmenartigen Gehäuse des Leistungshalbleitermoduls ausgeformt sein.

Das Leistungshalbleitermodul weist weiterhin Lastanschlusselemente, jeweils ausgebildet als Metallformkörper, mit äußeren und inneren Kontakteinrichtungen auf. Die jeweiligen äußeren Kontakteinrichtungen der einzelnen Lastanschlusselemente sind vorzugsweise parallel zur Substratoberfläche und von dieser beabstandet angeordnet. Die inneren Kontakteinrichtungen, die von den äußeren Kontakteinrichtungen ausgehen, reichen vorzugsweise senkrecht zur Substratoberfläche durch kanalartige Ausnehmungen in dem Brückenelement und bilden dort schaltungsgerecht die Kontakte der Lastanschlüsse aus. Als eine weitere bevorzugte Ausgestaltungsmöglichkeit sind die Last- und Hilfsanschlüsse als elektrisch leitende Federkontaktelemente angeordnet.

Es befinden sich auf dem Substrat im Bereich der strukturierten Leiterbahnen an mindestens zwei nicht von einem Leistungshalbleiterbauelement überdeckten Bereich Aussparungen, und dementsprechend an der dem Substrat zugewandten Seite der Druckeinrichtung, vorzugsweise ein Druckfinger des Brückenelements an mindestens zwei Stellen den Aussparungen entsprechend zugeordneten Rastnasen. Hierbei bedingt sich die maximale Fläche einer Aussparung und der dementsprechend zugeordneten Rastnase durch die maximale Fläche der dem Substrat zugewandten Seite eines Druckfingers. Die Tiefe einer Aussparung und entsprechend die Höhe einer der Aussparung zugeordneten Rastnase beträgt hierbei mindestens 20 von 100 der Tiefe der angeordneten Leiterbahn auf dem Substrat. Des Weiteren ist die Tiefe einer der Aussparung zugeordneten Rastnase in ihren maximalen Ausmaßen auf 100 von 100 der Tiefe des gesamten Substrats beschränkt.

Hierbei ist von Vorteil, dass der Kraftschluss zwischen den Kontakteinrichtungen und dem Substrates mittels der Druckeinrichtung gleichzeitig ohne weitere Aufwendung den Formschluss und/oder den Kraftschluss der mindestens zwei Aussparungen mit den ihnen entsprechend zugeordneten mindestens zwei Rastnasen ermöglicht, wodurch dem erfinderischen Gedanken entsprechend ein Verdrehen des Substrates gegen das Gehäuse verhindert wird.

Weiterhin ist von Vorteil, dass die Anfertigung der Aussparungen ohne weiteren Aufwand im Prozess der Strukturierung der Leiterbahnen erfolgen kann. Dementsprechend kann die Anfertigung der den Aussparungen entsprechend zugeordneten Rastnasen ohne weiteren Aufwand im Prozess der Anfertigung des vorzugsweise als Kunststoffkörper ausgestalteten Brückenelements erfolgen.

Weiterhin ist von Vorteil, dass ein seitliches Abrutschen der inneren Kontakteinrichtungen der Federkontaktelemente vermieden werden kann, wenn die innere Kontakteinrichtung an ihrer dem Substrat zugewandten Seite mit einer Rastnase beaufschlagt und eine entsprechend zugeordnete Aussparung auf dem Substrat angeordnet wird.

Besonders bevorzugte Weiterbildungen dieser Anordnung sind in der jeweiligen Beschreibung der Ausführungsbeispiele genannt. Die erfinderische Lösung wird zudem an Hand der Ausführungsbeispiele der Fig. 1 bis 6 weiter erläutert.

Fig. 1 zeigt eine vereinfachte Darstellung eines erfindungsgemäßen Leistungshalbleitermoduls.

Fig. 2 zeigt einen vergrößerten Ausschnitt einer ersten Ausgestaltung des erfindungsgemäßen Leistungshalbleitermoduls.in Seitenansicht.

Fig. 3 zeigt einen vergrößerten Ausschnitt einer weiteren Ausgestaltung des erfindungsgemäßen Leistungshalbleitermoduls.in Seitenansicht.

Fig. 4 zeigt einen vergrößerten Ausschnitt einer weiteren Ausgestaltung des erfindungsgemäßen Leistungshalbleitermoduls.in Draufsicht.

Fig. 5 zeigt eine vereinfachte Darstellung eines erfindungsgemäßen Leistungshalbleitermoduls mit Gehäuse und einen vergrößerten Ausschnitt eines erfindungsgemäßen Abschnitts.

Fig. 6 zeigt eine weitere Ausgestaltung eines erfindungsgemäßen Leistungshalbleitermoduls.

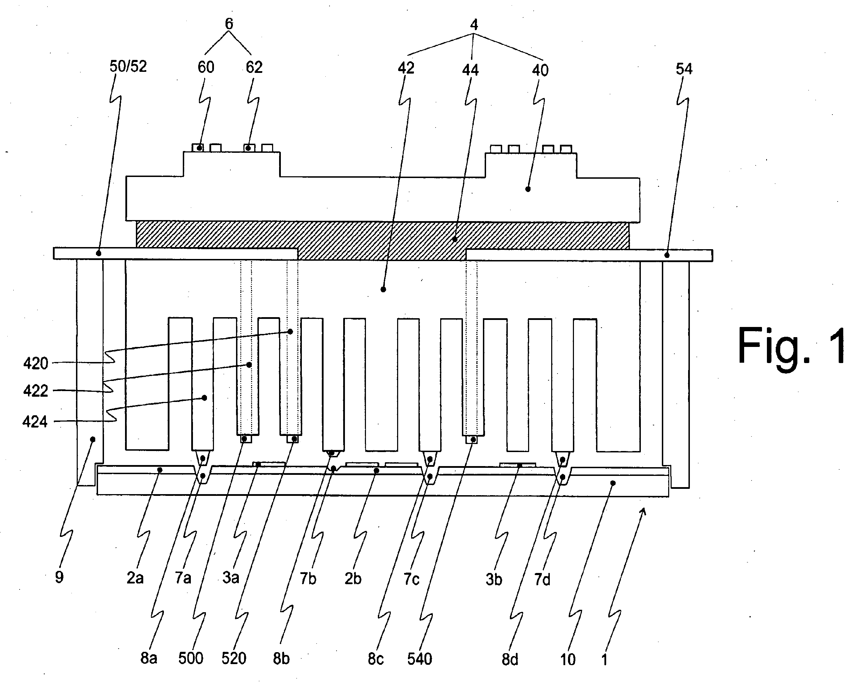

Fig. 1 zeigt ein vereinfacht dargestelltes grundplattenloses Leistungshalbleitermodul mit einem Substrat (1) mit einem Isolierstoffkörper (10) und mit auf dem Substrat angeordneten strukturierten Leiterbahnen (2a, 2b) und mit auf den Leiterbahnen angeordneten Leistungshalbleiterbauelementen (3a, 3b). Weiterhin weist das Leistungshalbleitermodul eine Druckeinrichtung (4) mit einem Druck einleitenden Element (40), sowie einem Brückenelement (42) auf; Weiterhin weist die Druckeinrichtung zusätzlich ein Kissenelement (44) zur Druckspeicherung und der Aufrechterhaltung konstanter Druckverhältnisse auf. Das Brückenelement (42) besteht hierbei vorzugsweise aus einem Kunststoffkörper mit einer Mehrzahl dem Substrat zugewandten Druckfingern (420, 422, 424). Weiterhin weist das Leistungshalbleitermodul ein (hier durch gepunktete Linien schematisch dargestelltes) Gehäuse (9) auf.

Die auf dem Substrat (1) angeordneten Leiterbahnen (2a, 2b) weisen Last- und Hilfspotentiale auf, welche der elektrischen Kontaktierung mit den nach außen führenden Last (50, 52, 54)- und Hilfsanschlüssen (60, 62) dienen. Hierbei wird die elektrische Kontaktierung zwischen den angeordneten Leiterbahnen (2a, 2b) und den Last- und Hilfsanschlüssen durch innere Kontakteinrichtungen (500, 520, 540) ermöglicht, welche in Abschnitten senkrecht zur Substratoberfläche durch kanalartige Aussparungen im Brückenelelement geführt werden.

Die erfindungsgemäßen mindestens zwei Aussparungen (7a-d) befinden sich an mindestens zwei nicht von Halbleiterbauelementen überdeckten Bereichen auf den strukturierten Leiterbahnen des Substrats. Beispielhaft sind einige Aussparungen zylinderförmig, andere kuppel- kegelstumpf- oder kreuzförmig ausgestaltet (hier im Querschnitt nicht unterscheidbar dargestellt). Weiterhin betragen einige Aussparungen (7a, 7c, 7d) 50 von 100 Tiefe der Dicke der angeordneten strukturierten Leiterbahn, andere (7b) 70 von 100 Tiefe der Dicke des gesamten Substrates.

Die erfindungsgemäßen mindestens zwei Rastnasen (8a-d) befinden sich an den dem Substrat zugewandten Seiten von mindestens einem Druckfinger in entsprechender Zuordnung zu den erfindungsgemäßen Aussparungen (7a-d).

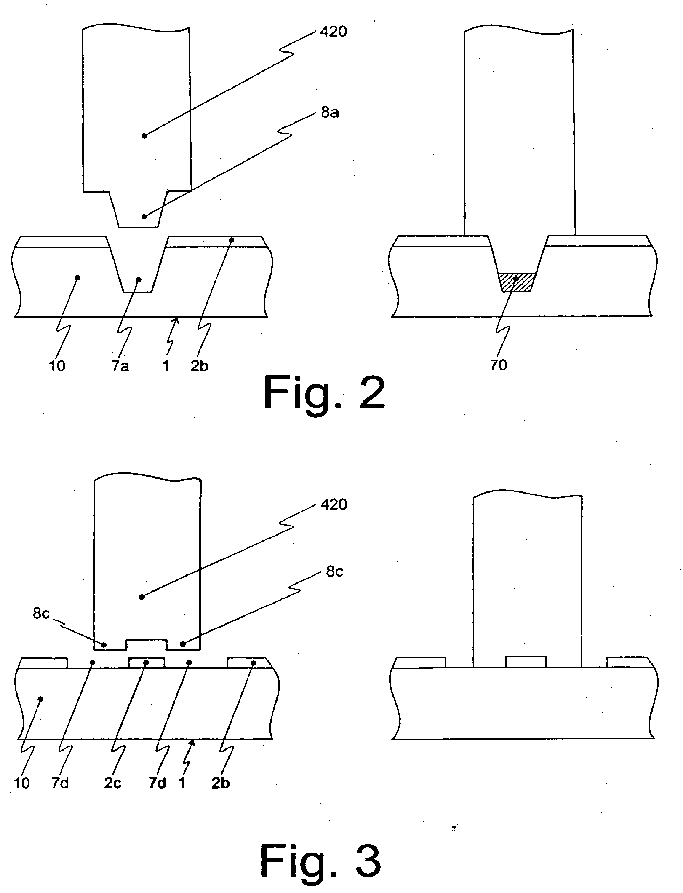

Fig. 2 zeigt einen vergrößerten Ausschnitt einer ersten Ausgestaltung des erfindungsgemäßen Leistungshalbleitermoduls in Seitenansicht mit einem Substrat (1) mit einem Isolierstoffkörper (10) und mit auf dem Substrat angeordneten strukturierten Leiterbahnen (2a, 2b) und mit einer erfindungsgemäßen Aussparung (7a), welche hier kegelstumpfförmig und mit einer Tiefe von 70 von 100 der gesamten Dicke des Substrats ausgestaltet ist. Weiterhin dargestellt ist ein senkrecht in Richtung der Substratoberfläche reichender Druckfinger (420) des Brückenelements (42) und einer der Aussparung (7a) entsprechend zugeordneten Rastnase (8a), welche in Verbindung mit einer Druckeinrichtung (4, hier nicht dargestellt.) eine kraftschlüssige Verbindung mit der Aussparung im Substrat (Fig. 2, rechte Bildseite) ergibt. Hier erreicht die Tiefe der Rastnase nicht 100 von 100 der Tiefe der Aussparung, sondern lässt ein Restvolumen der Aussparung frei (70).

Fig. 3 zeigt einen vergrößerten Ausschnitt einer weiteren Ausgestaltung des erfindungsgemäßen Leistungshalbleitermoduls in Seitenansicht mit einem Substrat (1) mit einem Isolierstoffkörper (10) und mit auf dem Substrat angeordneten Leiterbahnen (2a, 2b). Das Brückenelement (42) weist hier zwei Rastnasen (8c) auf. Auf dem Substrat sind zwei Aussparungen (7d) ausgebildet, indem die Leiterbahnen (2a, 2b) entsprechend unterbrochen wurden. In diese beiden Ausnehmungen (7d) sind die Rastnasen (8c) derart angeordnet, dass der zwischen den beiden Rastnasen (8c) verbliebene Teil der Leitbahn (2c) mit den beiden Rastnasen (8c) eine form- bzw. kraftschlüssige Verbindung (Fig. 3, rechte Bildseite) eingeht, obwohl die Aussparungen (7d) selbst breiter ausgebildet sind als die ihnen zugeordneten Rastnasen (8c).

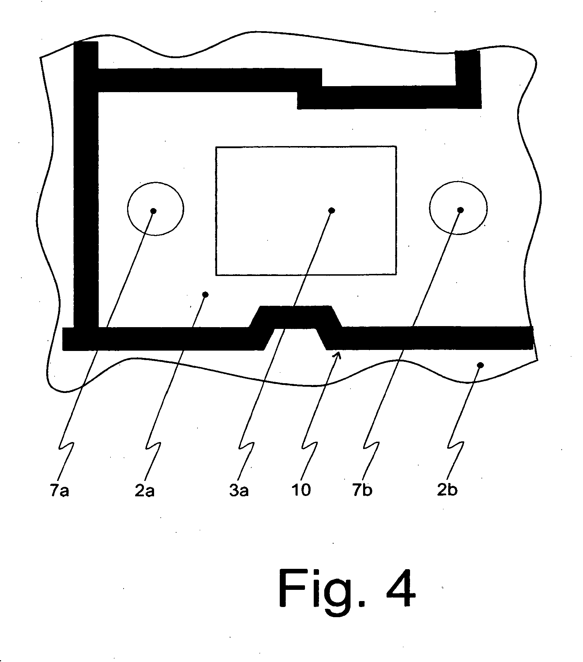

Fig. 4 zeigt ein erfindungsgemäßes Leistungshalbleitermodul (1) in Draufsicht auf einen Ausschnitt eines Substrats (1) mit auf dem Substrat angeordneten strukturierten Leiterbahnen (2a, 2b) und mit einem Isolierstoffkörper (10), welcher in Draufsicht lediglich im Bereich der Leiterbahnenstrukturierung sichtbar wird. Weiterhin dargestellt ist ein beispielhaftes Halbleiterbauelement (3a), sowie zwei erfindungsgemäße Aussparungen (7a, 7b), welche an zwei nicht von dem Halbleiterbauelement überdeckten Bereichen auf beispielhaft einer der angeordneten strukturierten Leiterbahnen (2a) des Substrats angeordnet sind, wobei die erfindungsgemäßen Aussparungen hier beispielhaft zylinderförmig ausgestaltet sind.

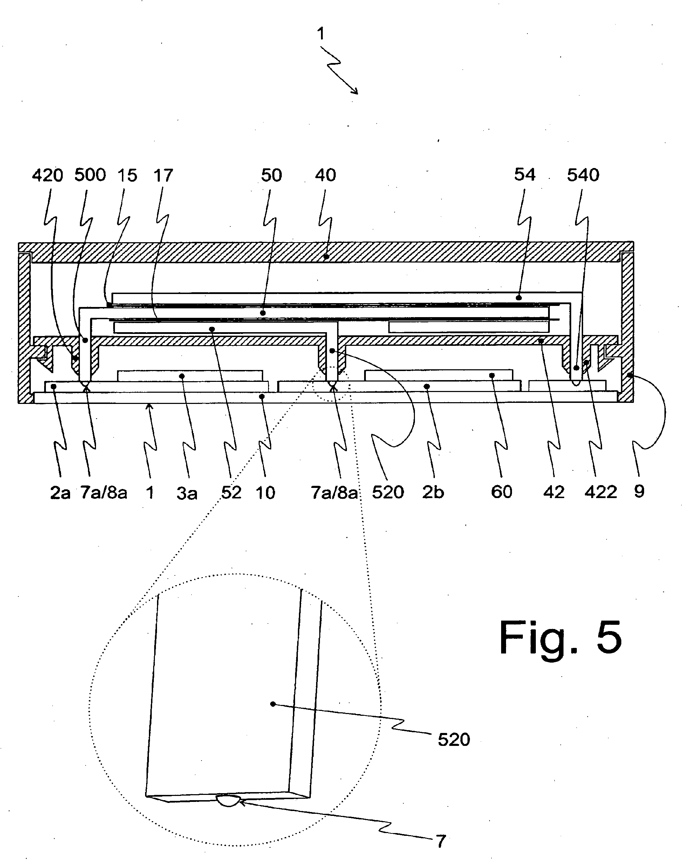

Fig. 5 zeigt eine weitere vereinfacht dargestellte Ausgestaltung eines erfindungsgemäßen Leistungshalbleitermoduls mit einem rahmenartigen Gehäuse (9), mit einem Substrat (1) mit einem Isolierstoffkörper (10) und mit auf dem Substrat angeordneten strukturierten Leiterbahnen (2a, 2b) und mit auf den Leiterbahnen angeordneten Leistungshalbleiterbauelementen (3a, 3b). Weiterhin sind die Lastanschlusselemente (50, 52, 54) als Metallformkörper ausgebildet, die je einen bandartigen Abschnitt parallel zur Substratoberfläche aufweisen und einen Stapel bilden und die einzelnen Lastanschlusselemente durch eine notwendige Isolierung (15, 17) voneinander beabstandet sind. Notwendige Hilfsanschlusselemente sind aus Gründen der Übersichtlichkeit in dieser Schnittzeichnung nicht dargestellt.

Die Druckeinrichtung (4) ist hierbei mit einem Druck einleitendes Element (40) und mit den Lastanschlüssen ausgestaltet, welche den Druck auf das Substrat einleiten. Hierbei findet der Kraftschluss direkt mittels der inneren Kontakteinrichtungen der Lastanschlüsse auf die strukturierten Leiterbahnen (2a, 2b) des Substrats (1) statt. Die erfindungsgemäßen mindestens zwei Aussparungen (7a, 7b) und die ihnen zugeordneten Rastnasen (8a, 8b) sind hier kuppelförmig ausgestaltet, wobei die zugeordneten Rastnasen an der den Leiterbahnen zugewandten Seite der inneren Kontakteinrichtungen (500, 520, 540) der Lastanschlüsse (50, 52, 54) angebracht sind.

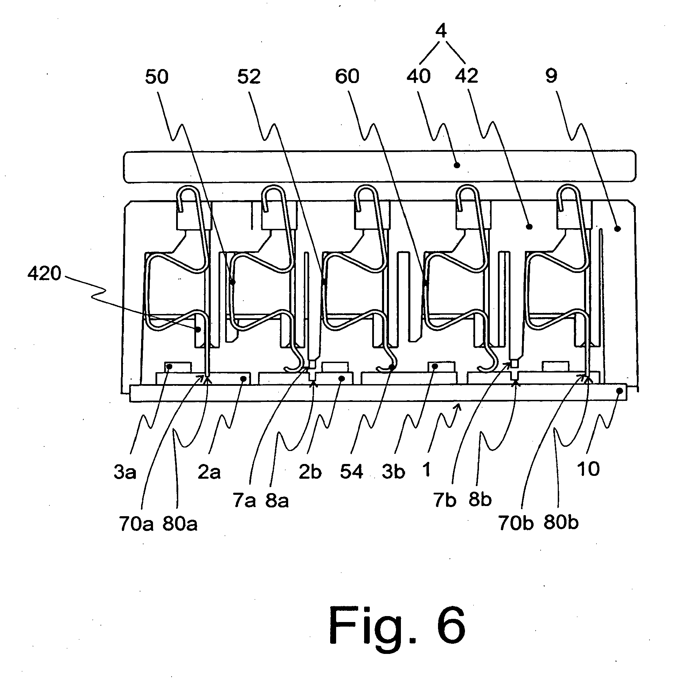

Fig. 6 zeigt eine weitere vereinfacht dargestellte Ausgestaltung eines erfindungsgemäßen Leistungshalbleitermoduls mit einem Substrat (1) mit einem Isolierstoffkörper (10) und mit auf dem Substrat angeordneten strukturierten Leiterbahnen (2a, 2b) und mit auf den Leiterbahnen angeordneten Leistungshalbleiterbauelementen (3a, 3b). Hierbei ist die Druckeinrichtung (4) ausgestaltet als ein Druck einleitende Element (40) und ein Brückenelement (42), wobei das Brückenelement einstückig mit dem rahmenartigen Gehäuse (9) des Leistungshalbleitermoduls ausgestaltet ist und die Druckeinrichtung aufgrund der Flexibilität der Federkontaktelemente auf ein Kissenelement verzichtet. Weiterhin sind die Last- (50, 52) und Hilfsanschlusselemente (60) als Federkontaktelemente ausgestaltet, wobei die elektrische Kontaktierung zu den strukturierten Leiterbahnen durch innere Kontakteinrichtungen (54) ausgebildet sind, welche in Abschnitten senkrecht zur Substratoberfläche durch kanalartige Aussparungen im Brückenelement (42) geführt werden. Die erfindungsgemäßen mindestens zwei Aussparungen (7a, 7b) und die ihnen zugeordneten Rastnasen (8a, 8b) sind zylinderförmig aufgeformt und betragen 30 von 100 Tiefe der Dicke des gesamten Substrats (1).

Alternativ oder zusätzlich sind an den inneren Kontaktierungen der Federkontaktelemente (50) zu den strukturierten Leiterbahnen Rastnasen (80a, 80b) angebracht, welche wiederum entsprechend eine form- und kraftschlüssige Verbindung mit den ihnen zugeordneten Aussparungen (70a, 70b) auf der zugeordneten Leiterbahn eingehen. Diese Rastnasen (80a, 80b) können bei der hier dargestellten Ausbildung der Federn als Fortsätze des Federkörpers ausgebildet sein. Bei nicht dargestellten Schraubenfedern, die beispielhaft aus einem Metalldraht gebildet sind, kann die innere Kontaktierung, die als gerader Drahtabschnitt ausgebildet ist, selbst die Rastnase bilden.

## Patentansprüche

1. Leistungshalbleitermodul mit mindestens einem Substrat (1) mit mindestens einem Halbleiterbauelement (3a, 3b), mit einem Gehäuse (9), mit einer Druckeinrichtung (4) und mit nach außen führenden Last- (50, 52, 54) und Hilfsanschlusselementen (6, 60, 62),
wobei das Substrat (1) einen Isolierstoffkörper (10) aufweist und auf dessen erster dem Inneren des Leistungshalbleitermoduls zugewandten Hauptfläche Leiterbahnen (2a, 2b) mit Last- und Hilfspotentialen angeordnet sind,
wobei die dem Inneren des Leistungshalbleitermoduls zugewandte Hauptfläche des Substrats im Bereich der angeordneten Leiterbahnen (2a, 2b) an mindestens zwei nicht von Leistungshalbleiterbauelementen überdeckten Bereichen mindestens zwei Aussparungen (7a, 7b, 7c ,7d) aufweist und die Druckeinrichtung (4) an ihrer dem Substrat zugewandten Seite an mindestens zwei Stellen den Aussparungen zugeordnete und darin form- und/oder kraftschlüssig angeordnete Rastnasen (8a, 8b, 8c, 8d) aufweist.

2. Leistungshalbleitermodul nach Anspruch 1,
wobei die Druckeinrichtung ein elastisches Kissenelement (44) aufweist, welches zwischen einem Druck einleitenden Druckelement (40) und einem Brückenelement (42) angeordnet ist.

3. Leistungshalbleitermodul nach Anspruch 2,
wobei das Brückenelement (42) als ein Kunststoffkörper mit einem dem Kissenelement (44) zugewandten flächigen Teilkörper ausgestaltet ist, von dem eine Mehrzahl von Druckfingern (420, 422, 424) in Richtung der Substratoberfläche ausgehend angeordnet sind.

4. Leistungshalbleitermodul nach Anspruch 1,
wobei die Rastnasen kegelstumpfförmig oder kuppelförmig oder zylinderförmig oder kreuzförmig oder podestförmig ausgestaltet sind und die ihnen zugeordneten Aussparungen (8a, 8b, 8c) entsprechend zu ihrer Aufnahme geformt sind.

5. Leistungshalbleitermodul nach Anspruch 2,
wobei die Lastanschlusselemente (50, 52, 54) in Abschnitten senkrecht zur Substratoberfläche durch kanalartige Ausnehmungen des Brückenelements (42) angeordnet sind und an der dem Substrat (1) zugewandten Seite Kontakteinrichtungen (500, 520, 540) zur elektrischen Kontaktierung und mit den auf dem Substrat angeordneten Leiterbahnen (2a, 2b) aufweisen.

6. Leistungshalbleitermodul nach Anspruch 2,
wobei das Gehäuse (9) das Brückenelement (42) und das mindestens eine Substrat (1) seitlich rahmenartig umschließt.

7. Leistungshalbleitermodul nach Anspruch 1,
wobei das Druck einleitende Druckelement (40) den oberen Abschluss des Leistungshalbleitermoduls bildet.

8. Leistungshalbleitermodul nach Anspruch 1,
wobei die Aussparungen (7a, b, c, d) in ihrer minimalen Tiefe 20 von 100 und in ihrer maximalen Tiefe 100 von 100 der Dicke des Substrates (1) aufweisen.

9. Leistungshalbleitermodul nach Anspruch 1,
wobei die den Aussparungen zugeordneten Rastnasen (8a, b, c, d) in ihrer minimalen Tiefe 20 von 100 und in ihrer maximalen Tiefe 100 von 100 der Dicke des Substrates (1) aufweisen.

10. Leistungshalbleitermodul nach Anspruch 1,
wobei mindestens ein Lastanschlusselement (50, 52, 54) selbst einen Teil der Druckeinrichtung (4) ausbildet.

## Claims

1. Power semiconductor module having at least one substrate (1) having at least one semiconductor component (3a, 3b), having a housing (9), having a pressure device (4) and having load connection elements (50, 52, 54) and auxiliary connection elements (6, 60, 62) which lead to the outside, wherein the substrate (1) has an insulating material body (10), and conductor tracks (2a, 2b) with load and auxiliary potentials are arranged on the first main area of the said body which faces the interior of the power semiconductor module, wherein the main area of the substrate, which faces the interior of the power semiconductor module, has at least two cutouts (7a, 7b, 7c, 7d) in the region of the arranged conductor tracks (2a, 2b) in at least two regions which are not covered by power semiconductor components, and the pressure device (4) has latching lugs (8a, 8b, 8c, 8d), which are associated with the recesses and are arranged in the latter in an interlocking and/or force-fitting manner, at at least two points on its side which faces the substrate.

2. Power semiconductor module according to Claim 1, wherein the pressure device has an elastic cushion element (44) which is arranged between a pressureintroducing pressure element (40) and a bridge element (42).

3. Power semiconductor module according to Claim 2, wherein the bridge element (42) is designed as a plastic body having a flat partial body which faces the cushion element (44) and from which a plurality of pressure fingers (420, 422, 424) start in the direction of the substrate surface.

4. Power semiconductor module according to Claim 1, wherein the latching lugs are designed in the form of a truncated cone or in the form of a dome or in the form of a cylinder or in the form of a cross or in the form of a pedestal, and the cutouts (8a, 8b, 8c) which are associated with the said latching lugs are shaped in a corresponding manner in order to accommodate the said latching lugs.

5. Power semiconductor module according to Claim 2, wherein sections of the load connection elements (50, 52, 54) are arranged at right angles to the substrate surface through channel-like recesses in the bridge element (42) and have, on the side which faces the substrate (1), contact devices (500, 520, 540) for making electrical contact with the conductor tracks (2a, 2b) which are arranged on the substrate.

6. Power semiconductor module according to Claim 2, wherein the housing (9) laterally surrounds the bridge element (42) and the at least one substrate (1) in a frame-like manner.

7. Power semiconductor module according to Claim 1, wherein the pressure-introducing pressure element (40) forms the upper termination of the power semiconductor module.

8. Power semiconductor module according to Claim 1, wherein the minimum depth of the cutouts (7a, b, c, d) is 20% of the thickness of the substrate (1) and the maximum depth of the said cutouts is 100% of the thickness of the said substrate.

9. Power semiconductor module according to Claim 1, wherein the minimum depth of the latching lugs (8a, b, c, d) which are associated with the recesses is 20% of the thickness of the substrate (1) and the maximum depth of the said latching lugs is 100% of the thickness of the said substrate.

10. Power semiconductor module according to Claim 1, wherein at least one load connection element (50, 52, 54) itself forms part of the pressure device (4).

## Revendications

1. Module de puissance à semi-conducteur présentant au moins un substrat (1) doté d'au moins un composant semi-conducteur (3a, 3b), d'un boîtier (9), d'un ensemble de poussée (4), d'éléments (50, 52, 54) de raccordement de charge et d'éléments (6, 60, 62) de raccordement auxiliaire, tous conduisant vers l'extérieur,
le substrat (1) présentant un corps (10) en matériau isolant et des pistes conductrices (2a, 2b) présentant des potentiels de charge et des potentiels auxiliaires étant disposées sur sa première surface principale tournée vers l'intérieur du module de puissance à semi-conducteur,
la surface principale du substrat tournée vers l'intérieur du module de puissance à semi-conducteur présentant au niveau des pistes conductrices (2a, 2b) au moins deux découpes (7a, 7b, 7c, 7d) en au moins deux emplacements non recouverts par les composants de puissance à semi-conducteur,
le dispositif de poussée (4) présentant sur son côté tourné vers le substrat, en au moins deux emplacements, des becs d'encliquetage (8a, 8b, 8c, 8d) associés aux découpes et disposés dans ces dernières en correspondance géométrique et/ou en correspondance mécanique.

2. Module de puissance à semi-conducteur selon la revendication 1, dans lequel le dispositif de poussée présente un élément (44) en coussin élastique disposé entre un élément de poussée (40) exerçant une poussée et un élément de pontage (42).

3. Module de puissance à semi-conducteur selon la revendication 2, dans lequel l'élément de pontage (42) est configuré comme corps en matière synthétique doté d'un corps partiel plat tourné vers l'élément (44) en coussin et duquel plusieurs doigts de poussée (420, 422, 424) partent en direction de la surface du substrat.

4. Module de puissance à semi-conducteur selon la revendication 1, dans lequel les becs d'encliquetage sont configurés en forme de tronc de cône, de coupole, de cylindre, de croix ou de colonne et les découpes (8a, 8b, 8c) qui leurs sont associées ont une forme adaptée à leur réception.

5. Module de puissance à semi-conducteur selon la revendication 2, dans lequel les éléments (50, 52, 54) de raccordement de charge sont disposés dans des sections perpendiculaires à la surface du substrat, traversent des découpes en forme de canal de l'élément de pontage (42) et présentent sur le côté tourné vers le substrat (1) des dispositifs de contact (500, 520, 540) qui assurent la contact électrique avec les pistes conductrices (2a, 2b) disposées sur le substrat.

6. Module de puissance à semi-conducteur selon la revendication 2, dans lequel le boîtier (9) entoure en forme de cadre latéral l'élément de pontage (42) et le ou les substrats (1).

7. Module de puissance à semi-conducteur selon la revendication 1, dans lequel l'élément de poussée (40) exerçant une poussée forme la fermeture supérieure du module de puissance à semi-conducteur.

8. Module de puissance à semi-conducteur selon la revendication 1, dans lequel les découpes (7a, b, c, d) représentent à leur profondeur minimale de 20 à 100 et dans leur profondeur maximale de 100 à 100 de l'épaisseur du substrat (1).

9. Module de puissance à semi-conducteur selon la revendication 1, dans lequel les becs d'encliquetage (8a, b, c, d) associés aux découpes représentent à leur profondeur minimale de 20 à 100 et à leur profondeur maximale de 100 à 100 de l'épaisseur du substrat (1).

10. Module de puissance à semi-conducteur selon la revendication 1, dans lequel au moins un élément (50, 52, 54) de raccordement de charge forme lui-même partie du dispositif de poussée (4).
